(19) **Europäisches Patentamt / European Patent Office / Office européen des brevets**

(11) **EP 4 768 946 A1**

(12) **EUROPEAN PATENT APPLICATION**
published in accordance with Art. 153(4) EPC

(43) Date of publication:
**01.07.2026 Bulletin 2026/27**

(21) Application number: **25861188.8**

(22) Date of filing: **30.07.2025**

(51) International Patent Classification (IPC):
**G01R 31/382** (2019.01)    **G01R 31/392** (2019.01)
**G01R 31/396** (2019.01)    **G01R 19/00** (2006.01)
**G01R 31/367** (2019.01)

(52) Cooperative Patent Classification (CPC):
**G01R 19/00; G01R 31/367; G01R 31/382;
G01R 31/392; G01R 31/396**

(86) International application number:
**PCT/KR2025/011334**

(87) International publication number:
**WO 2026/049323 (05.03.2026 Gazette 2026/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **29.08.2024 KR 20240116701**

(71) Applicant: **LG Energy Solution, Ltd.
Seoul 07335 (KR)**

(72) Inventors:
• **YOON, Du Seong**
  **Daejeon 34122 (KR)**
• **LEE, Bom Jin**
  **Daejeon 34122 (KR)**
• **YOON, Ho Byung**
  **Daejeon 34122 (KR)**
• **JEON, Chul Min**
  **Daejeon 34122 (KR)**
• **KWAK, Min**
  **Daejeon 34122 (KR)**
• **KIM, Yoon Kyu**
  **Daejeon 34122 (KR)**

(74) Representative: **Plasseraud IP
104 Rue de Richelieu
CS92104
75080 Paris Cedex 02 (FR)**

(54) **BATTERY DIAGNOSIS DEVICE AND OPERATION METHOD THEREOF**

(57)    A battery diagnosis device according to an embodiment disclosed in this disclosure includes an interface configured to acquire a plurality of charging/discharging data of a plurality of battery units and one or more processors configured to acquire a plurality of voltage-capacity data representing a relationship between a voltage change amount and a capacity change amount for each of the plurality of battery units based on the plurality of charging/discharging data, acquire a plurality of feature points corresponding to a plurality of charge/discharging cycles for each of the plurality of battery units based on the plurality of voltage-capacity data, and diagnose an abnormality of a specific battery unit based on an average change amount corresponding to feature points of the plurality of battery units and a specific change amount corresponding to a feature point of a specific battery unit.

```
                    ( START )
                        |
ACQUIRE PLURALITY OF CHARGING/DISCHARGING DATA —— 405
                        |
ACQUIRE PLURALITY OF VOLTAGE-CAPACITY DATA —— 410
                        |
ACQUIRE PLURALITY OF FEATURE POINTS —— 415
                        |
DIAGNOSE ABNORMALITY OF SPECIFIC BATTERY UNIT —— 420
                        |
                     ( END )
```

FIG. 4

EP 4 768 946 A1

**Description**

## TECHNICAL FIELD

### Cross-reference to Related Applications

This application claims priority from Korean Patent Application No. 10-2024-0116701, filed on August 29, 2024, the disclosure of which is incorporated by reference herein.

### Technical Field

Embodiments disclosed in this document relate to a battery diagnosis device and an operating method thereof.

## BACKGROUND ART

Research and development on secondary batteries is being have been actively conducted recently. Here, secondary batteries are batteries that can be charged and discharged, and include both conventional Ni/Cd batteries, Ni/MH batteries, and recent lithium ion batteries. Among secondary batteries, lithium ion batteries have the advantage of having much higher energy density than conventional Ni/Cd batteries, Ni/MH batteries, etc. In addition, lithium ion batteries may be manufactured to be small and lightweight, and thus the lithium ion batteries are used as a power source for mobile devices. In addition, the scope of use of the lithium ion batteries has expanded to include a power source for electric vehicles, and the lithium ion batteries are attracting attention as a next-generation energy storage medium.

In addition, secondary batteries may generally be used as a battery pack, which includes battery modules in which a plurality of battery cells are connected in series and/or parallel. Furthermore, secondary batteries may be used as a battery rack, which includes a plurality of battery modules and a rack frame that accommodates the battery modules.

Such battery cells, battery modules, battery packs, or battery racks may be utilized in various devices. As an example, batteries may be utilized not only in mobile devices such as mobile phones, laptops, smartphones, and smart pads, but also in fields such as electric vehicles (EVs, HEVs, PHEVs) and large-capacity energy storage systems (ESSs).

The state and operation of these batteries may be managed and controlled by a battery management system (BMS). The battery management system may be included with the battery within a single device.

In addition, the battery management system may manage and control the battery while being separated from the device containing the battery. For example, the battery management system may be implemented as a separate server device. In this case, the battery management system may collect battery data and vehicle data from vehicles, etc., and use the collected data to manage and control the battery.

## DISCLOSURE OF THE INVENTION

### TECHNICAL PROBLEM

When a short circuit or other type of failure occurs inside the battery, the possibility of damage to devices containing the battery (e.g., EV, ESS) may increase. Accordingly, there is a need for a method capable of reducing the possibility of damage to devices containing the battery by detecting an abnormal state of the battery.

In the past, determining whether a battery was defective required a process of disassembling some battery samples. For example, when lithium plating occurs due to a defective negative electrode overhang, the risk of the battery catching fire increases. Therefore, it is important to preemptively determine whether an overhang defect has occurred in the battery and prevent the possibility of catching fire. In the past, a process of disassembling some battery samples was required for this purpose. However, a process of analyzing the presence or absence of actual defects after disassembling the battery sample was problematic in that the process takes a lot of manpower and time.

Accordingly, it is necessary to automatically diagnose whether the battery is defective without disassembling the battery.

Embodiments disclosed in this document may provide a battery diagnosis device and operating method thereof capable of diagnosing an abnormality of a battery based on charging/discharging data of the battery.

The technical problems of the embodiments disclosed in this document are not limited to the technical problems mentioned above, and other technical problems that are not mentioned will be clearly understood by those skilled in the art from the description below.

## TECHNICAL SOLUTION

A battery diagnosis device according to an embodiment disclosed in this disclosure includes an interface configured to acquire a plurality of charging/discharging data of a plurality of battery units and one or more processors configured to acquire a plurality of voltage-capacity data representing a relationship between a voltage change amount and a capacity change amount for each of the plurality of battery units based on the plurality of charging/discharging data, acquire a plurality of feature points corresponding to a plurality of charge/discharging cycles for each of the plurality of battery units based on the plurality of voltage-capacity data, and diagnose an abnormality of a specific battery unit based on an average change amount corresponding to feature points of the plurality of battery units and a specific change amount corresponding to a feature point of a specific battery unit.

In the battery diagnosis device according to an embodiment disclosed in this document, the one or more processors may be configured to acquire the average change amount corresponding to the feature points of the plurality of battery units and the specific change amount corresponding to the feature point of the specific battery unit based on a time window, and diagnose the abnormality of the specific battery unit based on the average change amount and the specific change amount.

In the battery diagnosis device according to an embodiment disclosed in this document, the one or more processors may be configured to set a threshold change amount range based on the average change amount, and diagnose the abnormality of the specific battery unit based on the threshold change amount range and the specific change amount.

In the battery diagnosis device according to an embodiment disclosed in this document, the one or more processors may be configured to set the threshold change amount range based on a standard deviation corresponding to the average change amount and the average change amount.

In the battery diagnosis device according to an embodiment disclosed in this document, the one or more processors may be configured to acquire, based on a first time window to an n-th time window, a first average change amount to an n-th average change amount corresponding to the feature points of the plurality of battery units, and a first specific change amount to an n-th specific change amount corresponding to the feature point of the specific battery unit, and diagnose the abnormality of the specific battery unit based on the first average change amount to the n-th average change amount and the first specific change amount to the n-th specific change amount.

In the battery diagnosis device according to an embodiment disclosed in this document, the one or more processors may be configured to set a k-th threshold change amount range based on a k-th average change amount corresponding to a k-th time window among the first time window to the n-th time window, and diagnose the specific battery unit as a candidate defective battery unit when a k-th specific change amount falls outside the k-th threshold change amount range.

In the battery diagnosis device according to an embodiment disclosed in this document, the one or more processors may be configured to set at least one adjacent threshold change amount range based on at least one adjacent average change amount corresponding to at least one adjacent time window adjacent to the k-th time window, and diagnose the candidate defective battery unit as a defective battery unit when at least one adjacent specific change amount in the adjacent time window falls outside the adjacent threshold change amount range.

In the battery diagnosis device according to an embodiment disclosed in this document, the one or more processors may be configured to acquire a plurality of feature points corresponding to the plurality of charge/discharging cycles for each of the plurality of battery units based on at least some of extreme points of the plurality of voltage-capacity data.

A battery diagnosis method according to an embodiment disclosed in this disclosure may include an operation of acquiring a plurality of charging/discharging data of a plurality of battery units an operation of acquiring a plurality of voltage-capacity data representing a relationship between a voltage change amount and a capacity change amount for each of the plurality of battery units based on the plurality of charging/discharging data, an operation of acquiring a plurality of feature points corresponding to a plurality of charge/discharging cycles for each of the plurality of battery units based on the plurality of voltage-capacity data, and an operation of diagnosing an abnormality of a specific battery unit based on an average change amount corresponding to feature points of the plurality of battery units and a specific change amount corresponding to a feature point of a specific battery unit.

In the battery diagnosis method according to an embodiment disclosed in this document, the operation of diagnosing the abnormality of the specific battery unit may include an operation of acquiring the average change amount corresponding to the feature points of the plurality of battery units and the specific change amount corresponding to the feature point of the specific battery unit based on a time window and diagnosing the abnormality of the specific battery unit based on the average change amount and the specific change amount.

In the battery diagnosis method according to an embodiment disclosed in this document, the operation of diagnosing the abnormality of the specific battery unit may include an operation of setting a threshold change amount range based on the average change amount, and diagnosing the abnormality of the specific battery unit based on the threshold change amount range and the specific change amount.

In the battery diagnosis method according to an embodiment disclosed in this document, the operation of diagnosing the abnormality of the specific battery unit may include an operation of setting the threshold change amount range based on a standard deviation corresponding to the average change amount and the average change amount.

In the battery diagnosis method according to an embodiment disclosed in this document, the operation of diagnosing the abnormality of the specific battery unit may include an operation of acquiring, based on a first time window to an n-th time window, a first average change amount to an n-th average change amount corresponding to the feature points of the plurality of battery units, and a first specific change amount to an n-th specific change amount corresponding to the feature point of the specific battery unit, and diagnosing the abnormality of the specific battery unit based on the first average change amount to the n-th average change amount and the first specific change amount to the n-th specific change amount.

In the battery diagnosis method according to an embodiment disclosed in this document, the operation of diagnosing the abnormality of the specific battery unit may include an operation of setting a k-th threshold change amount range based on a k-th average change amount corresponding to a k-th time window among the first time window to the n-th time window, and diagnosing the specific battery unit as a candidate defective battery unit when a k-th specific change amount falls outside the k-th threshold change amount range.

In the battery diagnosis method according to an embodiment disclosed in this document, the operation of diagnosing the abnormality of the specific battery unit may include an operation of setting at least one adjacent threshold change amount range based on at least one adjacent average change amount corresponding to at least one adjacent time window adjacent to the k-th time window, and diagnosing the candidate defective battery unit as a defective battery unit when at least one adjacent specific change amount in the adjacent time window falls outside the adjacent threshold change amount range.

## ADVANTAGEOUS EFFECTS

According to the embodiments disclosed in this document, an abnormality of a battery can be diagnosed based on charging/discharging data of the battery without disassembling the battery.

According to the embodiments disclosed in this document, manpower and time consumed to diagnose the abnormality of the battery can be reduced.

According to the embodiments disclosed in this document, manpower and time consumed to diagnose battery abnormalities can be reduced.

According to the embodiments disclosed in this document, the shipment or use of defective batteries can be prevented, thereby preventing a fire from occurring in the battery battery.

In addition, various effects directly or indirectly identified through this document may be provided.

## BRIEF DESCRIPTION OF THE DRAWINGS

FIG. 1 is a block diagram of a battery diagnosis device according to an embodiment.
FIG. 2 is a diagram illustrating voltage-capacity data according to an embodiment.
FIG. 3 is a diagram illustrating a change amount corresponding to feature points of a plurality of battery units.
FIG. 4 is a flowchart illustrating an operation of a battery diagnosis device according to an embodiment.
FIG. 5 shows a computing system that executes an operating method of a battery diagnosis device according to an embodiment.

## MODE FOR CARRYING OUT THE INVENTION

Hereinafter, various embodiments of the present disclosure will be described with reference to the accompanying drawings. However, this is not intended to limit the present disclosure to specific embodiments, and it should be understood that various modifications, equivalents, and/or alternatives of the embodiments of the present disclosure are included.

It should be understood that various embodiments and terms used in the embodiments are not intended to limit the technical features described in this document to specific embodiments, but should be understood to include various modifications, equivalents, or substitutes of the corresponding embodiments. In connection with the description of the drawings, similar reference numerals may be used for similar or related components. A singular form of a noun corresponding to an item may include one item or a plurality of items unless the relevant context clearly indicates otherwise.

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof. Terms such as "first", "second", "firstly", "secondly", "A", "B", "(a)" or "(b)" may be used merely to distinguish one component from another and, unless otherwise stated, do not limit the components in any other respect (e.g., importance or order).

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

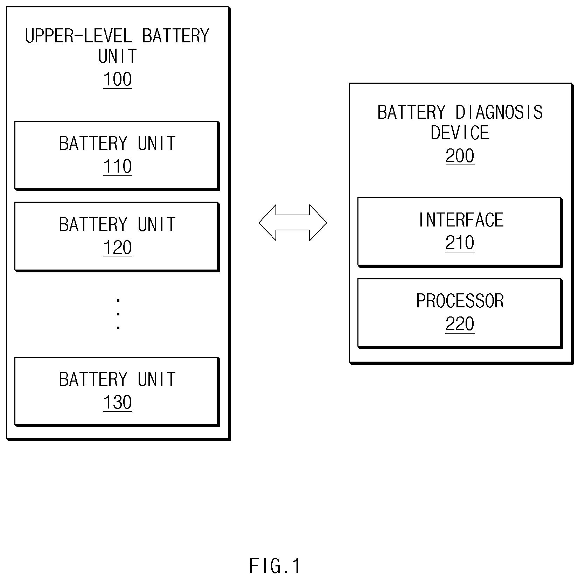

FIG. 1 is a block diagram of a battery diagnosis device according to an embodiment.

Referring to FIG. 1, an upper-level battery unit 100 may include a plurality of battery units 110, 120, and 130. According to an embodiment, the upper-level battery unit 100 may be a battery for storing and providing surplus power by being included in an energy storage system (ESS). According to an embodiment, the upper-level battery unit 100 may be a battery mounted inside an electric vehicle to provide power to an electric vehicle.

According to an embodiment, a battery diagnosis device 200 may diagnose an abnormality of a specific battery unit based on charging/discharging data acquired from the upper-level battery unit 100 or the battery units 110, 120, and 130. In the present disclosure, the battery units 110, 120, and 130 may refer to battery packs, battery modules, or battery cells.

According to an embodiment, the battery diagnosis device 200 may be formed integrally with the upper-level battery unit 100 or the battery units 110, 120, and 130. In this case, the battery diagnosis device 200 may be included in a battery management system (BMS) of the upper-level battery unit 100 or the battery units 110, 120, and 130.

According to an embodiment, the battery diagnosis device 200 may be formed separately from the upper-level battery unit 100 or the battery units 110, 120, and 130. In this case, the battery diagnosis device 200 may be implemented as an external server connected to the upper-level battery unit 100 or the battery units 110, 120, and 130 through a wireless network.

In addition, the operation of the battery diagnosis device 200 below may be performed by a battery management system (BMS) in a vehicle, and may also be performed in various devices such as a server, cloud, charger, or charger/discharger.

According to an embodiment, the battery diagnosis device 200 may include an interface 210 and one or more processors 220.

According to an embodiment, the interface 210 may acquire charging/discharging data of the battery units 110, 120, and 130. For example, the interface 210 may acquire information on the voltage, current, capacity, and/or temperature of the battery units 110, 120, and 130 and construct charging/discharging data based on the acquired information. In this case, the interface 210 may include a sensor for acquiring information on the voltage, current, capacity, and/or temperature, and a processor for constructing charging/discharging data based on the acquired information. As another example, the interface 210 may receive charging/discharging data of the battery units 110, 120, and 130. In this case, the interface 210 may include a communication circuit capable of performing network communication in a wired manner and/or wirelessly.

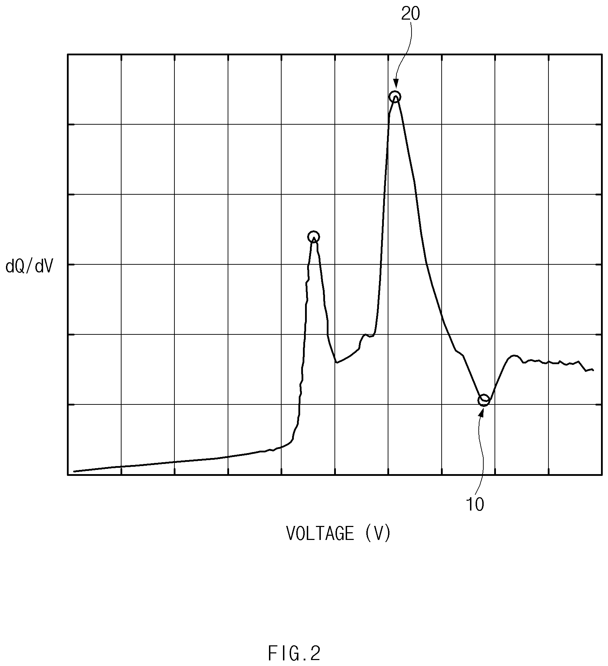

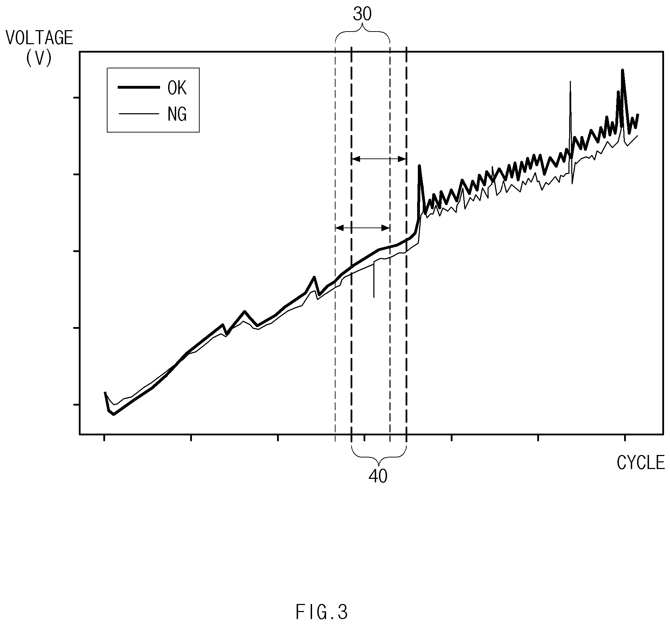

According to an embodiment, the processor 220 may calculate a determination value (e.g., voltage-capacity data, feature feature points, average change amount, specific change amount, etc.) based on the charging/discharging data acquired by the interface 210. Various embodiments in which the processor 220 calculates the determination value will be described in detail with reference to FIGS. 2 and 3, which will be described below.

According to an embodiment, the processor 220 may diagnose an abnormality of the battery unit based on the calculated determination value. For example, the processor 220 may diagnose the abnormality of the battery unit based on a specific change amount of a specific battery unit and an average change amount of a plurality of battery units.

The processor 220 described above may be implemented as a single processor or as separate processors. Here, the processor may execute software to control at least one other component (e.g., hardware or software component) of the battery diagnosis device 200 and perform various data processing or computations.

According to the embodiment, the battery diagnosis device 200 may transmit battery diagnosis results to an external source (e.g., a cloud server or a user terminal). Here, the cloud server may provide a service for providing the battery diagnosis results to each of a plurality of users. In addition, a user terminal may include a terminal such as a personal computer (PC) or a smartphone. As an example, the battery diagnosis device 200 may provide information on an abnormal battery unit to the user terminal through a communication unit (not shown) and may also provide information on the abnormal battery unit through a display provided in a vehicle, a charger, etc.

Hereinafter, various embodiments in which the processor 220 diagnoses an abnormality of the battery units 110, 120, and 130 will be described with reference to FIGS. 2 and 3. FIGS. 2 and 3 may be described using the configuration of FIG. 1 (e.g., the interface 210 and the processor 220).

First, the processor 220 may acquire a plurality of voltage-capacity data representing a relationship between a voltage change amount and capacity change amount of each of the plurality of battery units 110, 120, and 130 based on the plurality of charging/discharging data.

FIG. 2 is a diagram illustrating voltage-capacity data. Here, the horizontal axis corresponds to a voltage value V in a specific cycle (e.g., the 50th charging cycle) of a battery unit (e.g., 110), and the vertical axis corresponds to a value $dQ/dV$ obtained by differentiating the capacity of the battery unit 110 in a specific cycle (e.g., the 50th charging cycle) by voltage.

Referring to FIG. 2, the relationship between the voltage change amount and the capacity change amount in the specific cycle (e.g., the 50th charging cycle) of the battery unit 110 may be confirmed.

For reference, for convenience of description, FIG. 2 illustrates voltage-capacity data in a single cycle (the 50th charging cycle) of a single battery unit 110 as an example, but a similar description may also be applied to voltage-capacity data in a plurality of cycles of a plurality of battery units 110, 120, and 130. In addition, in FIG. 2, a charging cycle is described as an example for convenience of description, but is not limited thereto, and a similar description may also be applied to a discharging cycle.

As an example, the processor 220 may acquire, based on a plurality of charging/discharging data, $m\_1$-th voltage-capacity data to $n\_1$-th voltage-capacity data that respectively correspond to an m-th cycle to n-th cycle of the battery unit 110. In addition, the processor 220 may acquire $m\_2$-th voltage-capacity data to $n\_2$-th voltage-capacity data that respectively correspond to an m-th cycle to n-th cycle of the battery unit 120. In addition, the processor 220 may acquire $m\_3$-th voltage-capacity data to $n\_3$-th voltage-capacity data that respectively correspond to an m-th to n-th cycles of the battery unit 130.

In addition, the processor 220 may acquire a plurality of feature points corresponding to a plurality of charge/discharging cycles for each of the plurality of battery units 110, 120, and 130 based on a plurality of voltage-capacity data (e.g., $m\_1$-th voltage-capacity data to $n\_1$-th voltage-capacity data, $m\_2$-th voltage-capacity data to $n\_2$-th voltage-capacity data, and $m\_3$-th voltage-capacity data to $n\_3$-th voltage-capacity data).

According to an embodiment, the processor 220 may acquire a plurality of feature points corresponding to a plurality of charge/discharging cycles for each of the plurality of battery units 110, 120, and 130 based on at least some of extreme points of the plurality of voltage-capacity data.

As an example, referring to FIG. 2, the processor 220 may acquire a 50th feature point corresponding to a 50th charging cycle of the battery unit 110 based on the coordinates of an extreme point 10 having the minimum value among a plurality of extreme points of the voltage-capacity data in a specific cycle (the 50th charging cycle) of the battery unit 110. For example, a value of the 50th feature point corresponding to the 50th charging cycle of the battery unit 110 may be an x-coordinate value $x_1$ of the extreme point 10. However, the value of the 50th feature point is not limited to the x-coordinate value $x_1$ of the extreme point 10, and may also be a y-coordinate value $y_1$ of the extreme point 10.

As another example, referring to FIG. 2, the processor 220 may acquire the 50th feature point corresponding to the 50th charging cycle of the battery unit 110 based on the coordinates of an extreme point 20 having the maximum value among a plurality of extreme points of the voltage-capacity data in the specific cycle (the 50th charging cycle) of the battery unit 110. For example, the value of the 50th feature point corresponding to the 50th charging cycle of the battery unit 110 may be an x-coordinate value $x_2$ of the extreme point 20. However, the value of the 50th feature point is not limited to the x-coordinate value $x_2$ of the extreme point 20, and may also be a y-coordinate value $y_1$ of the extreme point 20.

For reference, for convenience of description, FIG. 2 illustratively describes a process of acquiring a feature point in a single cycle (the 50th charge cycle) of a single battery unit 110. Similar descriptions may also be applied to a process of acquiring feature points in a plurality of (charging cycles or discharging cycles) of a plurality of battery units 110, 120, and 130.

As an example, the processor 220 may acquire an $m\_1$-th feature point to an $n\_1$-th feature point that respectively correspond to an m-th cycle to an n-th cycle of the battery unit 110 based on a plurality of voltage-capacity data data ($m\_1$-th voltage-capacity data to $n\_1$-th voltage-capacity data). In addition, the processor 220 may acquire an $m\_2$-th feature point to an $n\_2$-th feature point that respectively correspond to an m-th cycle to an n-th cycle of the battery unit 120 based on a plurality of voltage-capacity data data ($m\_2$-th voltage-capacity data to $n\_2$-th voltage-capacity data). In addition, the processor 220 may acquire an $m\_3$-th feature point to an $n\_3$-th feature point that respectively correspond to an m-th cycle to an n-th cycle of the battery unit 130 based on a plurality of voltage-capacity data data (m_3-th voltage-capacity data to n_3-th voltage-capacity data).

Further, the processor 220 may diagnose an abnormality of a specific battery unit based on an average change amount corresponding to the feature points of the plurality of battery units 110, 120, and 130 and a specific change amount corresponding to a feature point of the specific battery unit.

For reference, as an aging phenomenon due to the use of the battery unit, the value of the feature point (e.g., the voltage V or the differential value dQ/dV) of the battery unit may increase as the number of cycles increases. Therefore, based on these characteristics, an abnormality of the battery unit may be diagnosed.

According to an embodiment, the change amount corresponding to the feature point of the battery unit may be a slope of the feature point in a specific time period (e.g., a specific time window).

For example, when a k-th charging cycle to a (k+10)-th charging cycle are referred to as a specific time period (a specific time window), a slope (i.e., a specific change amount) of a feature point of a specific battery unit 110 in a specific time window may be a value which is obtained by dividing a value, which is obtained by subtracting a value of the feature point of the specific battery unit 110 in the k-th charging cycle from a value of the feature point of the specific battery unit 110 in the (k+10)-th charging cycle, by a length (e.g., 10) of a time period.

In addition, when the k-th charging cycle to the (k+10)-th charging cycle are referred to as the specific time period (the specific time window), a slope (i.e., an average change) of feature points of the plurality of battery units 110, 120, and 130 in a specific time window is a value which is obtained by dividing a value, which is obtained by subtracting a sum of the feature points of the plurality of battery units 110, 120, and 130 in the k-th charging cycle from a sum of the feature points of the plurality of battery units 110, 120, and 130 in the (k+10)-th charging cycle, by a product of the number of battery units 3 and the length (e.g., 10) of the time period.

However, the slope of the feature point is merely an example to describe the degree of change in the feature point, and the change amount of the feature point disclosed in this document is not limited to the slope of the feature point. For example, the change amount of the feature point may be a difference value between a start feature point and an end feature point in a specific time period (a specific time window). For example, the change amount of a feature point corresponding to a specific time period of a battery unit may be a value obtained by subtracting the k-th feature point corresponding to the end point (e.g., the k-th charging cycle) of the specific time period from the (k+10)-th feature point corresponding to the end point (e.g., the (k+10)-th charging cycle) of the specific time period.

In addition, the processor 220 may diagnose an abnormality of the specific battery unit based on the average change of a plurality of battery units 110, 120, and 130 and the specific change amount of a specific battery unit.

As an example, the processor 220 may diagnose an abnormality of a specific battery unit 120 based on whether the specific change amount of the specific battery unit (e.g., 120) is similar to the average change amount of the plurality of battery units 110, 120, and 130.

According to an embodiment, the processor 220 may set a threshold change amount range based on the average change amount of the plurality of battery units 110, 120, and 130.

According to an embodiment, the processor 220 may set the threshold change amount range by additionally using a standard deviation corresponding to the average change amount of the plurality of battery units 110, 120, and 130.

For example, the processor 220 may set the threshold change amount range according to Equation 1 below. For reference, $\alpha$ (scale factor) in Equations 1 and 2 below is a hyperparameter whose appropriate value may be set based on charging/discharging data.

threshold change amount $\geq$ (average change amount - standard deviation*$\alpha$)          [Equation 1]

Further, the processor 220 may diagnose an abnormality of the specific battery unit 120 based on the threshold change amount range and the specific change amount. For example, when the specific change amount of the specific battery unit 120 is 0.15 in a state where threshold change amount range is set to 0.2 or higher based on a value (e.g., 0.2) obtained by subtracting the product (e.g., 0.1) of the standard deviation and scale factor from the average change amount (0.3) of the plurality of battery units 110, 120, and 130, the processor 220 may diagnose that an abnormality has occurred in the specific battery unit 120.

As another example, the processor 220 may set the threshold change amount range according to Equation 2 below.

(average change amount - standard deviation*$\alpha$) $\leq$ threshold change amount < (average change amount + standard deviation*$\alpha$)          [Equation 2]

Further, the processor 220 may diagnose an abnormality of a specific battery unit 120 based on the threshold change amount range and the specific change amount. For example, when the specific change amount of the specific battery unit 120 is 0.35 in a state where the threshold change amount range is set to 0.3 or more and less than 0.5 based on a value (e.g., 0.3) obtained by subtracting the product (e.g., 0.1) of the standard deviation and scale factor from the average change amount (0.4) of the plurality of battery units 110, 120, and 130 and a value (0.5) obtained by adding the product (0.1) of standard deviation and scale factor to the average change amount (0.4), the processor 220 may diagnose that the specific battery unit 120 is normal.

The above description describes a case where the processor 220 diagnoses the abnormality of the battery unit based on the change amount (or slope) in a single time period (a single time window), but is not limited thereto. For example, the processor 220 may diagnose the abnormality of the battery unit based on the change amount in a plurality of adjacent time periods (a plurality of time windows).

As an example, (i) when the number of time windows in which a specific battery unit (e.g., 130) is diagnosed as having an abnormality is greater than or equal to a preset number or consecutive times or more, (ii) when the number of time windows in which the specific battery unit 130 is diagnosed as having an abnormality is greater than or equal to a preset number, (iii) when the ratio of the total number of time windows to the number of time windows in which the specific battery unit 130 is diagnosed as having an abnormality is greater than a preset ratio, the processor 220 may diagnose that the specific battery unit 130 is actually having an abnormality.

According to an embodiment, the processor 220 may acquire a first average change amount to an n-th average change amount corresponding to feature points of the plurality of battery units 110, 120, and 130 and a first specific change amount to an n-th specific change amount corresponding to the feature point of a specific battery unit (e.g., 130) based on a first time window to an n-th time window. Here, n is an integer greater than or equal to 2.

For example, the processor 220 may acquire a first average change amount corresponding to a feature point in a first time window, a second average change amount corresponding to a feature point in a second time window, a third average change amount corresponding to a feature point in a third time window, and a fourth average change amount corresponding to a feature point in a fourth time window of the plurality of battery units 110, 120, and 130. In addition, the processor 220 may acquire a first specific change amount corresponding to a feature point in a first time window, a second specific change amount corresponding to a feature point in a second time window, a third specific change amount corresponding to a feature point in a third time window, and a fourth specific change amount corresponding to a feature point in a fourth time window of the specific battery unit (e.g., 130).

Further, the processor 220 may diagnose an abnormality of the specific battery unit (e.g., 130) based on the first average change amount to the n-th average change amount and the first specific change amount to the n-th specific change amount.

In this case, the processor 220 may set the first threshold change amount range to the n-th threshold change amount range based on the first average change amount to the n-th average change amount that respectively correspond to the first time window to the n-th time window, respectively.

For example, the processor 220 may set a 100th threshold change amount range based on a 100th average change amount corresponding to a 100th time window among the first time window to the n-th time window.

Further, the processor 220 may diagnose a specific battery unit 130 as a candidate defective battery unit when the specific change amount of the specific battery unit (e.g., 130) in each of the first through n-th time windows falls outside the corresponding threshold change amount range.

For example, the processor 220 may diagnose a specific battery unit 130 as a candidate defective battery unit when the 100th specific change amount of the specific battery unit (e.g., 130) corresponding to the 100th time window falls outside the 100th threshold change amount range.

The processor 220 may also perform a process similar to that of the k-th time window for time windows adjacent to the k-th time window (e.g., at least one of the (k-2)-th time window, the (k-1)-th time window, the (k+1)-th time window, and the (k+20)-th time window). If a specific battery unit (e.g., 130) diagnosed as a candidate defective battery unit has a specific change amount that falls outside the threshold variation change amount for the adjacent time window, the processor 220 may diagnose the specific battery unit 130 as a defective battery unit.

For reference, the length of width (size) and period (moving range) of the time window are hyperparameters, and appropriate values may be set according to the charging/discharging data. For example, the size of the time window may be 10 cycles, and the moving range thereof may be 5 cycles. In this case, the start point of the first time window may be the first cycle, and the end point thereof may be the eleventh cycle, and the start point of the second time window adjacent to the first time window may be the sixth cycle and the end point thereof may be the sixteenth cycle.

As an example, the processor 220 may diagnose that an abnormality has occurred in a specific battery unit when a specific change amount of the battery unit falls outside the corresponding threshold change amount range in four consecutive time windows.

For example, the processor 220 may diagnose a specific battery unit as a defective battery unit when each of the specific change amounts (e.g., the 101st specific change amount to the 103rd specific change amount) of a specific battery unit corresponding to three time windows (e.g., the 101st time window to the 103rd time window) that are consecutive and adjacent to the 100th time window falls outside each of the corresponding threshold change amount ranges (e.g., the 101st threshold change amount range to the 103rd threshold change amount range).

FIG. 3 is a diagram illustrating the results of the processor 220 diagnosing an abnormality of a battery unit based on change amounts corresponding to feature points in a plurality of time windows of a first battery unit OK and a second battery unit NG. Here, the horizontal axis corresponds to the number of cycles, and the vertical axis corresponds to the value of the feature point in each cycle (e.g., the voltage value as the x-coordinate value of the extreme point). As described above, it can be confirmed that the feature point value of the battery unit tends to increase as the cycle value on the horizontal axis increases.

Referring to FIG. 3, since a specific change amount (e.g., 0.25) of the first battery unit OK satisfies a threshold change amount range (e.g., 0.2 or greater) set based on an average change amount (e.g., 0.3) of a plurality of battery units, it can be confirmed that the first battery unit OK is diagnosed as normal.

For example, as a k-th specific change amount in a k-th time window 30 of the first battery unit OK is determined to be within a k-th threshold change amount range set based on a k-th average change amount in the k-th time window 30 of a plurality of battery units 110, 120, and 130 and a (k+1)-th specific change amount in a (k+1)-th time window 40 of the first battery unit OK is determined to be within a (k+1)-th threshold change amount range set based on a (k+1)-th average change amount in the k-th time window 40 of a plurality of battery units 110, 120, and 130, the processor 220 may diagnose the first battery unit OK as normal.

On the other hand, as a specific change amount (e.g., 0.1) of the second battery unit NG dissatisfies the threshold change amount range (e.g., 0.2 or greater) set based on the average change amount (e.g., 0.3) of a plurality of battery units, it can be confirmed that the second battery unit NG is diagnosed as defective.

For example, as a k-th specific change amount in the k-th time window 30 of the second battery unit NG is determined to be outside a k-th threshold change amount range set based on a k-th average change amount in the k-th time window 30 of the plurality of battery units 110, 120, and 130 and a (k+1)-th specific change amount in a (k+1)-th time window 40 of the second battery unit NG is determined to be outside a (k+1)-th threshold change amount range set based on a (k+1)-th average change amount in the k-th time window 40 of a plurality of battery units 110, 120, and 130, the processor 220 may diagnose the second battery unit NG as normal.

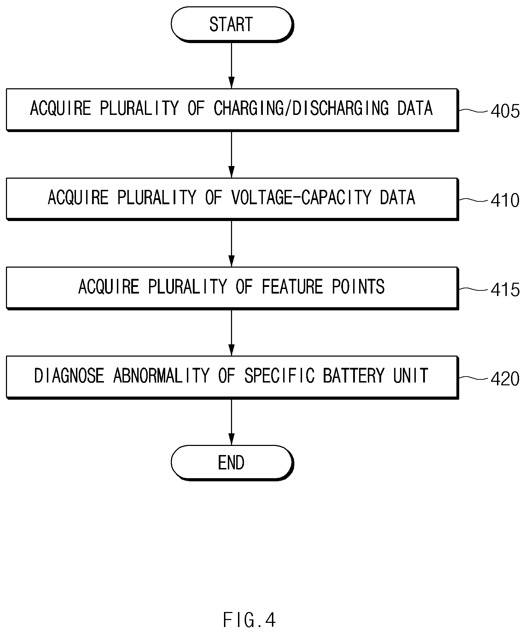

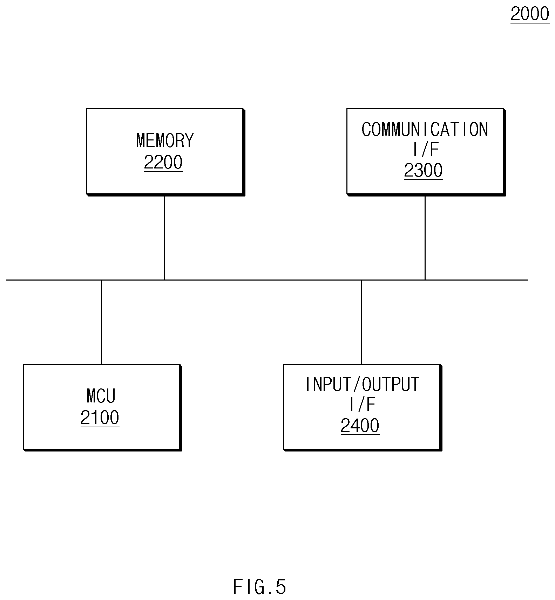

FIGS. 4 and 5 are flowcharts illustrating operations of a battery diagnosis device according to an embodiment. FIG. 4 may be a description of the operation of the battery diagnosis device 200 of FIG. 1, and may be described using the configuration of FIG. 1.

The embodiment illustrated in FIG. 4 is only one embodiment, and the order of steps according to various embodiments of the present invention may be different from that illustrated in FIG. 4, and some steps illustrated in FIG. 4 may be omitted, the order between steps may be changed, or steps may be merged.

Referring to FIG. 4, in operation 405, the battery diagnosis device 200 may acquire a plurality of charging/-discharging data of a plurality of battery units 110, 120 and/or 130.

In operation 410, the battery diagnosis device 200 may acquire a plurality of voltage-capacity data each representing the relationship between the voltage change amount and the capacity change amount of each of the plurality of battery units 110, 120, and 130 based on the plurality of charge-discharge data acquired in operation 405.

In operation 415, the battery diagnosis device 200 may acquire a plurality of feature points that respectively correspond to a plurality of charge-discharging cycles for each of the plurality of battery units 110, 120, and 130 based on the plurality of voltage-capacity data.

In operation 420, the battery diagnosis device 200 may diagnose an abnormality of a specific battery unit based on an average change amount corresponding to feature points of the plurality of battery units 110, 120, and 130 and a specific change amount corresponding to a feature point of a specific battery unit. According to an embodiment, the battery diagnosis device 200 may acquire the average change amount corresponding to the feature points of the plurality of battery units 110, 120, and 130 and the specific change amount corresponding to the feature point of a specific battery unit based on a time window and diagnose an abnormality of the specific battery unit based on the average change amount and the specific change amount. According to an embodiment, the battery diagnosis device 200 may set a threshold change amount range based on the average change amount and diagnose an abnormality of a specific battery unit based on the threshold change amount range and the specific change amount. According to an embodiment, the battery diagnosis device 200 may set the threshold change amount range based on a standard deviation corresponding to the average change amount and the average change amount. According to an embodiment, the battery diagnosis device 200 may acquire, based on a first time window to an n-th time window, a first average change amount to an n-th average change amount corresponding to the feature points of the plurality of battery units 110, 120, and 130, and a first specific change amount to an n-th specific change amount corresponding to the feature point of the specific battery unit, and diagnose the abnormality of the specific battery unit based on the first average change amount to the n-th average change amount and the first specific change amount to the n-th specific change amount. According to an embodiment, the battery diagnosis device 200 may set a k-th threshold change amount range based on a k-th average change amount corresponding to a k-th time window among the first time window to the n-th time window and diagnose the specific battery unit as a candidate defective battery unit when a k-th specific change amount falls outside the k-th threshold change amount range. According to an embodiment, the battery diagnosis device 200 may set at least one adjacent threshold change amount range based on at least one adjacent average change amount corresponding to at least one adjacent time window adjacent to the k-th time window, and diagnose the candidate defective battery unit as a defective battery unit when at least one adjacent specific change amount in the adjacent time window falls outside the adjacent threshold change amount range. According to an embodiment, the battery diagnosis device 200 may acquire a plurality of feature points corresponding to the plurality of charging/discharging cycles for each of the plurality of battery units based on at least some of extreme points of the plurality of voltage-capacity data.

FIG. 5 illustrates a computing system that executes an operating method of a battery diagnosis device according to an embodiment disclosed in this document.

Referring to FIG. 5, a computing system 2000 according to an embodiment disclosed in this document may include an MCU 2100, a memory 2200, a communication interface 2300, and an input/output interface 2400.

The MCU 2100 may be a processor that executes various programs (e.g., battery diagnosis programs) stored in the memory 2200 and performs the functions of the battery diagnosis device 200 described with reference to FIGS. 1 to 3, or a processor that executes the operating method of the battery diagnosis device described with reference to FIG. 4.

The memory 2200 may store various programs related to calculating the voltage, current, and/or capacity of the battery unit, a battery connection failure determination program, a battery data transmission program, a battery diagnosis program, etc. In addition, the memory 2200 may store various data, such as sensing values and temperatures for each battery unit.

A plurality of such memories 2200 may be provided as needed. The memory 2200 may be a volatile memory or a nonvolatile memory. The memory 2200 used as the volatile memory may be RAM, DRAM, SRAM, etc. The memory 2200 used as the nonvolatile memory may be ROM, PROM, EAROM, EPROM, EEPROM, flash memory, etc. The examples of the memories 2200 listed above are only examples, but are not limited to these examples.

The input/output I/F 2400 may provide an interface that allows data to be transmitted and received by connecting an input device (not shown) such as a keyboard, mouse, or touch panel and an output device (not shown) such as a display with the MCU 2100.

The communication I/F 2300 is a configuration that can transmit and receive various data with the server, and may be various devices that can support wired or wireless communication. For example, the battery diagnosis device 200 may transmit and receive programs for determining whether or not battery cells are abnormal, various data, battery data transmission programs, battery diagnosis programs, etc. to and from a separately provided external server through the communication I/F 2300.

In this way, the operating method of the battery management device according to an embodiment disclosed in this document may be recorded in the memory 2200 and executed by the MCU 2100.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

**Claims**

1. A battery diagnosis device, comprising:

   an interface configured to acquire a plurality of charging/discharging data of a plurality of battery units; and
   one or more processors configured to acquire a plurality of voltage-capacity data representing a relationship between a voltage change amount and a capacity change amount for each of the plurality of battery units based on the plurality of charging/discharging data, acquire a plurality of feature points corresponding to a plurality of charge/discharging cycles for each of the plurality of battery units based on the plurality of voltage-capacity data, and diagnose an abnormality of a specific battery unit based on an average change amount corresponding to feature points of the plurality of battery units and a specific change amount corresponding to a feature point of a specific battery unit.

2. The battery diagnosis device of claim 1, wherein the one or more processors are configured to acquire the average change amount corresponding to the feature points of the plurality of battery units and the specific change amount corresponding to the feature point of the specific battery unit based on a time window and diagnose the abnormality of the specific battery unit based on the average change amount and the specific change amount.

3. The battery diagnosis device of claim 2, wherein the one or more processors are configured to set a threshold change amount range based on the average change amount and diagnose the abnormality of the specific battery unit based on the threshold change amount range and the specific change amount.

4. The battery diagnosis device of claim 3, wherein the one or more processors are configured to set the threshold change amount range based on a standard deviation corresponding to the average change amount and the average change amount.

5. The battery diagnosis device of claim 1, wherein the one or more processors are configured to acquire, based on a first time window to an n-th time window, a first average change amount to an n-th average change amount corresponding to the feature points of the plurality of battery units, and a first specific change amount to an n-th specific change amount corresponding to the feature point of the specific battery unit and diagnose the abnormality of the specific battery unit based on the first average change amount to the n-th average change amount and the first specific change amount to the n-th specific change amount.

6. The battery diagnosis device of claim 5, wherein the one or more processors are configured to set a k-th threshold change amount range based on a k-th average change amount corresponding to a k-th time window among the first time window to the n-th time window and diagnose the specific battery unit as a candidate defective battery unit when a k-th specific change amount falls outside the k-th threshold change amount range.

7. The battery diagnosis device of claim 6, wherein the one or more processors are configured to set at least one adjacent threshold change amount range based on at least one adjacent average change amount corresponding to at least one adjacent time window adjacent to the k-th time window and diagnose the candidate defective battery unit as a defective battery unit when at least one adjacent specific change amount in the adjacent time window falls outside the adjacent threshold change amount range.

8. The battery diagnosis device of claim 1, wherein the one or more processors are configured to acquire a plurality of feature points corresponding to the plurality of charge/discharging cycles for each of the plurality of battery units based on at least some of extreme points of the plurality of voltage-capacity data.

9. A battery diagnosis method, comprising:

an operation of acquiring a plurality of charging/discharging data of a plurality of battery units;
an operation of acquiring a plurality of voltage-capacity data representing a relationship between a voltage change amount and a capacity change amount for each of the plurality of battery units based on the plurality of charging/discharging data;
an operation of acquiring a plurality of feature points corresponding to a plurality of charge/discharging cycles for each of the plurality of battery units based on the plurality of voltage-capacity data; and
an operation of diagnosing an abnormality of a specific battery unit based on an average change amount corresponding to feature points of the plurality of battery units and a specific change amount corresponding to a feature point of a specific battery unit.

10. The battery diagnosis method of claim 9, wherein the operation of diagnosing the abnormality of the specific battery unit includes an operation of acquiring the average change amount corresponding to the feature points of the plurality of battery units and the specific change amount corresponding to the feature point of the specific battery unit based on a time window and diagnosing the abnormality of the specific battery unit based on the average change amount and the specific change amount.

11. The battery diagnosis method of claim 10, wherein the operation of diagnosing the abnormality of the specific battery unit includes an operation of setting a threshold change amount range based on the average change amount, and diagnosing the abnormality of the specific battery unit based on the threshold change amount range and the specific change amount.

12. The battery diagnosis method of claim 11, wherein the operation of diagnosing the abnormality of the specific battery unit includes an operation of setting the threshold change amount range based on a standard deviation corresponding to the average change amount and the average change amount.

13. The battery diagnosis method of claim 9, wherein the operation of diagnosing the abnormality of the specific battery unit includes an operation of acquiring, based on a first time window to an n-th time window, a first average change amount to an n-th average change amount corresponding to the feature points of the plurality of battery units, and a first specific change amount to an n-th specific change amount corresponding to the feature point of the specific battery unit and diagnosing the abnormality of the specific battery unit based on the first average change amount to the n-th average change amount and the first specific change amount to the n-th specific change amount.

14. The battery diagnosis method of claim 13, wherein the operation of diagnosing the abnormality of the specific battery unit includes an operation of setting a k-th threshold change amount range based on a k-th average change amount corresponding to a k-th time window among the first time window to the n-th time window and diagnosing the specific battery unit as a candidate defective battery unit when a k-th specific change amount falls outside the k-th threshold change amount range.

15. The battery diagnosis method of claim 14, wherein the operation of diagnosing the abnormality of the specific battery unit includes an operation of setting at least one adjacent threshold change amount range based on at least one adjacent average change amount corresponding to at least one adjacent time window adjacent to the k-th time window and diagnosing the candidate defective battery unit as a defective battery unit when at least one adjacent specific change amount in the adjacent time window falls outside the adjacent threshold change amount range.

UPPER-LEVEL BATTERY
UNIT
100

BATTERY UNIT
110

BATTERY UNIT
120

.
.
.

BATTERY UNIT
130

$\Longleftrightarrow$

BATTERY DIAGNOSIS
DEVICE
200

INTERFACE
210

PROCESSOR
220

FIG.1

FIG.2

FIG.3

```
                        ┌─────────────┐
                        │    START    │
                        └──────┬──────┘
                               │
                               ▼
        ┌──────────────────────────────────────────────┐
        │ ACQUIRE PLURALITY OF CHARGING/DISCHARGING DATA │──405
        └──────────────────────┬───────────────────────┘
                               │
                               ▼
        ┌──────────────────────────────────────────────┐
        │   ACQUIRE PLURALITY OF VOLTAGE-CAPACITY DATA   │──410
        └──────────────────────┬───────────────────────┘
                               │
                               ▼
        ┌──────────────────────────────────────────────┐
        │       ACQUIRE PLURALITY OF FEATURE POINTS      │──415
        └──────────────────────┬───────────────────────┘
                               │
                               ▼
        ┌──────────────────────────────────────────────┐
        │   DIAGNOSE ABNORMALITY OF SPECIFIC BATTERY UNIT │──420
        └──────────────────────┬───────────────────────┘
                               │
                               ▼
                        ┌─────────────┐
                        │     END     │
                        └─────────────┘
```

FIG.4

2000

```
                                   COMMUNICATION
        MEMORY                         I/F
         2200                          2300




        MCU                        INPUT/OUTPUT
        2100                           I/F
                                       2400
```

FIG.5

## INTERNATIONAL SEARCH REPORT

| International application No. |
| --- |
| **PCT/KR2025/011334** |

| A. | CLASSIFICATION OF SUBJECT MATTER |
| --- | --- |

**G01R 31/382**(2019.01)i; **G01R 31/392**(2019.01)i; **G01R 31/396**(2019.01)i; **G01R 19/00**(2006.01)i; **G01R 31/367**(2019.01)i

According to International Patent Classification (IPC) or to both national classification and IPC

| B. | FIELDS SEARCHED |
| --- | --- |

Minimum documentation searched (classification system followed by classification symbols)

G01R 31/382(2019.01); G01R 31/36(2006.01); G01R 31/367(2019.01); H01M 10/42(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (MOIP internal) & keywords: 배터리 유닛(battery unit), 충방전 데이터(charging and discharging data), 전압-용량 데이터(voltage-capacity data), 특징점(feature point), 변화량(change amount), 이상(abnormal), 진단(diagnosis)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | JP 5846054 B2 (TOYOTA MOTOR CORP.) 20 January 2016 (2016-01-20)<br>see paragraphs [0007], [0074]-[0081], [0092]-[0101] and claim 1. | 1-15 |
| Y | JP 2014-092471 A (TOYO SYSTEM CO., LTD.) 19 May 2014 (2014-05-19)<br>see paragraphs [0014]-[0017], [0032]-[0036], [0045], [0046]. | 1-15 |
| A | KR 10-2021-0150217 A (LG ENERGY SOLUTION, LTD.) 10 December 2021 (2021-12-10)<br>see paragraphs [0041]-[0051], [0058]-[0062]. | 1-15 |
| A | JP 7423583 B2 (YOKOGAWA ELECTRIC CORP.) 29 January 2024 (2024-01-29)<br>see paragraphs [0028], [0078], [0079] and claims 1-5. | 1-15 |
| A | KR 10-2022-0033350 A (LG ENERGY SOLUTION, LTD.) 16 March 2022 (2022-03-16)<br>see paragraphs [0051], [0059]. | 1-15 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **31 October 2025** | **02 November 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

EP 4 768 946 A1

## INTERNATIONAL SEARCH REPORT
### Information on patent family members

International application No.

**PCT/KR2025/011334**

| Patent document cited in search report | | | Publication date (day/month/year) | Patent family member(s) | | | Publication date (day/month/year) |
|---|---|---|---|---|---|---|---|
| JP | 5846054 | B2 | 20 January 2016 | CN | 102421959 | A | 18 April 2012 |
| | | | | CN | 102421959 | B | 09 December 2015 |
| | | | | CN | 202343397 | U | 25 July 2012 |
| | | | | CN | 203633281 | U | 11 June 2014 |
| | | | | EP | 2430229 | A1 | 21 March 2012 |
| | | | | EP | 2430229 | B1 | 01 March 2017 |
| | | | | JP | 2012-526586 | A | 01 November 2012 |
| | | | | JP | 2014-007025 | A | 16 January 2014 |
| | | | | JP | 5676574 | B2 | 25 February 2015 |
| | | | | KR | 10-1733392 | B1 | 11 May 2017 |
| | | | | KR | 10-2012-0018791 | A | 05 March 2012 |
| | | | | US | 2012-0042547 | A1 | 23 February 2012 |
| | | | | US | 8615909 | B2 | 31 December 2013 |
| | | | | WO | 2010-131148 | A1 | 18 November 2010 |
| JP | 2014-092471 | A | 19 May 2014 | JP | 5354416 | B1 | 27 November 2013 |
| KR | 10-2021-0150217 | A | 10 December 2021 | CN | 114270204 | A | 01 April 2022 |
| | | | | CN | 114270204 | B | 03 May 2024 |
| | | | | EP | 4063883 | A1 | 28 September 2022 |
| | | | | EP | 4063883 | A4 | 09 August 2023 |
| | | | | EP | 4063883 | B1 | 09 October 2024 |
| | | | | ES | 3001883 | T3 | 06 March 2025 |
| | | | | HU | E069417 | T2 | 28 March 2025 |
| | | | | JP | 2022-544981 | A | 24 October 2022 |
| | | | | JP | 7331326 | B2 | 23 August 2023 |
| | | | | KR | 10-2843320 | B1 | 05 August 2025 |
| | | | | PL | 4063883 | T3 | 03 February 2025 |
| | | | | US | 12044744 | B2 | 23 July 2024 |
| | | | | US | 2023-0333174 | A1 | 19 October 2023 |
| | | | | WO | 2021-246655 | A1 | 09 December 2021 |
| JP | 7423583 | B2 | 29 January 2024 | CN | 115877216 | A | 31 March 2023 |
| | | | | EP | 4166965 | A1 | 19 April 2023 |
| | | | | EP | 4166965 | B1 | 23 April 2025 |
| | | | | JP | 2023-051292 | A | 11 April 2023 |
| | | | | JP | 2024-040204 | A | 25 March 2024 |
| | | | | JP | 7699679 | B2 | 27 June 2025 |
| | | | | US | 2023-0093809 | A1 | 30 March 2023 |
| KR | 10-2022-0033350 | A | 16 March 2022 | CN | 115917344 | A | 04 April 2023 |
| | | | | EP | 4155748 | A1 | 29 March 2023 |
| | | | | EP | 4155748 | A4 | 13 December 2023 |
| | | | | EP | 4155748 | B1 | 14 August 2024 |
| | | | | ES | 2991380 | T3 | 03 December 2024 |
| | | | | HU | E068414 | T2 | 28 December 2024 |
| | | | | JP | 2023-515595 | A | 13 April 2023 |
| | | | | JP | 7362990 | B2 | 18 October 2023 |
| | | | | KR | 10-2652327 | B1 | 27 March 2024 |
| | | | | PL | 4155748 | T3 | 16 December 2024 |
| | | | | US | 2023-0280403 | A1 | 07 September 2023 |
| | | | | WO | 2022-055264 | A1 | 17 March 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240116701